# EUROPEAN PATENT APPLICATION

(11) **EP 3 462 825 A1**
(43) Date of publication of application: **03.04.2019**
(21) Application number: 17193697.4
(22) Date of filing: 28.09.2017
(51) Int. Cl.: H05K 9/00

(54) **APPARATUS AND METHOD FOR PROTECTING A DEVICE FROM ELECTROSTATIC DISCHARGE**

(71) Applicant: Vestel Elektronik Sanayi ve Ticaret A.S., 45030 Manisa (TR)
(72) Inventor: SARIARSLAN, Muhammet Kürsat, 45030 Manisa (TR)
(74) Representative: Flint, Adam

(57) **Abstract**

An apparatus protects a device (200) from electrostatic discharge. The apparatus has a magnetic field detector arranged to detect a magnetic field (212) associated with a build up of static charge arising from an entity in the vicinity of the device (200). The apparatus has controller arranged such that if the detected build up of static charge is above a threshold value, the controller initiates a protection arrangement to prevent damage to the device being caused by electrostatic discharge.

## Description

### Technical Field

The present disclosure relates to an apparatus and method for protecting a device from electrostatic discharge.

### Background

When a charged entity comes into contact with or sufficiently close to a grounded entity, it is possible for an electrostatic discharge event to occur between the two entities when there is sufficient electrostatic charge build up. Such discharges can cause damage to electronic devices.

### Summary

According to a first aspect disclosed herein, there is provided an apparatus for protecting a device from electrostatic discharge, the apparatus comprising:
a magnetic field detector arranged to detect a magnetic field associated with a build up of static charge arising from an entity in the vicinity of the device; and
a controller, the controller being arranged such that if the detected build up of static charge is above a threshold value, the controller initiates a protection arrangement to prevent damage to the device being caused by electrostatic discharge.

In an example, the apparatus is incorporated in the device.

In an example, the controller is arranged to initiate a protection arrangement that interrupts software running on the device.

In an example, the device comprises at least one ground connection for connecting the device to earth, wherein the controller is arranged to initiate a protection arrangement that disconnects said at least one ground connection.

In an example, the device comprises a plurality of electronic components each of which has an independent ground connection for connecting the electronic component directly to earth, wherein the controller is arranged to initiate a protection arrangement that disconnects the ground connection of each of the electronic components.

In an example, the device comprises a plurality of electronic components each of which has a ground connection to a main ground connection for connection to earth, wherein the controller is arranged to initiate a protection arrangement that disconnects the ground connection of each of the electronic components to the main ground connection.

In an example, the device comprises a plurality of groups of electronic components, each group comprising a plurality of electronic components and each group being connected directly to an independent common ground connection for connecting the electronic components of the group directly to earth, wherein the controller is arranged to initiate a protection arrangement that disconnects the ground connections of each of the groups of electronic components.

In an example the device comprises a plurality of electronic components each of which has a ground connection for connection to earth, wherein the controller is arranged to initiate a protection arrangement that connects the ground connection of at least one electronic component directly to earth without connecting at least one of the remaining electronic components to earth.

According to a second aspect disclosed herein, there is provided a method of protecting a device from electrostatic discharge, the method comprising:
detecting a magnetic field associated with a build up of static charge arising from an entity in the vicinity of the device;
determining whether the detected build up of static charge is above a threshold value associated with the device; and
initiating a protection arrangement to prevent damage to the device if the detected build up of static charge is above a threshold thereby to prevent damage to the device being caused by electrostatic discharge.

In an example, initiating a protection arrangement comprises interrupting software running on the device.

In an example, the device comprises at least one ground connection, wherein initiating a protection arrangement comprises disconnecting the ground connection associated with the device.

In an example, the device comprises a plurality of electronic components each of which has an independent ground connection for connecting the electronic component directly to earth, wherein initiating a protection arrangement comprises disconnecting the ground connection of each of the electronic components.

In an example, the device comprises a plurality of electronic components each of which has a ground connection to a main ground connection for connection to earth, wherein initiating a protection arrangement comprises disconnecting the ground connection of each of the electronic components to the main ground connection.

In an example, the device comprises a plurality of groups of electronic components, each group comprising a plurality of electronic components and each group being connected directly to an independent common ground connection for connecting the electronic components of the group directly to earth, wherein initiating a protection arrangement comprises disconnecting the ground connections of each of the groups of electronic components.

In an example, the device comprises a plurality of electronic components each of which has a ground connection for connection to earth, wherein initiating a protection arrangement comprises initiating a protection arrangement that connects the ground connection of at least one electronic component directly to earth without connecting at least one of the remaining electronic components to earth.

### Brief Description of the Drawings

To assist understanding of the present disclosure and to show how embodiments may be put into effect, reference is made by way of example to the accompanying drawings in which:
Figure 1a and 1b show schematically an example environment in which a charged entity approaches a device;
Figure 2 shows schematically a first example of operation of circuitry of a device being approached by a magnetic field;
Figure 3 shows schematically a second example of operation of circuitry of a device being approached by a magnetic field; and
Figure 4 shows schematically a third example of operation of circuitry of a device being approached by a magnetic field.

### Detailed Description

As mentioned previously, when a charged entity comes into contact with or sufficiently close to a grounded entity, it is possible for an electrostatic discharge event to occur between the two entities. Such electrostatic discharge can cause damage to electronic devices. The likelihood and magnitude of damage to devices can be exacerbated with frequent incidents of electrostatic discharge. Therefore, it is advantageous to have an apparatus for detecting the presence of electrostatic charge build up carried by an entity in the vicinity of the apparatus. The apparatus may then act accordingly to protect the device from damage that could result from discharge of the detected electrostatic charge build up.

According to examples described herein, there is provided an apparatus for protecting a device from electrostatic discharge. The apparatus comprises a magnetic field detector. The magnetic field detector is arranged to detect a magnetic field associated with a build up of static charge arising from an entity in the vicinity of the device. The apparatus comprises a controller. The controller is arranged such that if the detected build up of static charge is above a threshold value, the controller initiates a protection arrangement to prevent damage to the device being caused by electrostatic discharge.

Electrostatic charge build up can arise on an entity when electrons are transferred between it and another entity, causing one or both entities to become charged. When the now charged entity comes within close proximity of an earthed entity, a sudden flow of electricity between the two entities may occur. This is referred to as electrostatic discharge or ESD.

The most spectacular form of ESD is the spark, which occurs when a heavy electric field creates an ionized conductive channel in air. This can have a varied effect on the entities involved in the ESD, from minor to severe damage to electronic equipment, and fires and explosions if the air contains combustible gases or particles. A spark is triggered when the electric field strength exceeds approximately 4-30 kV/cm, which is the typical range of dielectric field strength of air. Nevertheless, many ESD events occur without a visible or audible spark. A person carrying a relatively small electric charge may not feel a discharge that is sufficient to damage sensitive electronic components. Devices can be sensitive to very low voltages, with some devices being able to be damaged by discharges as small as 30V. These invisible forms of ESD can also cause outright device failures or less obvious forms of degradation that may affect the long term reliability and performance of electronic devices. The degradation in some devices may not become evident until well into their service life.

Practical improvements can be made to the environment to reduce the occurrence of electrostatic discharge at the manufacturing stages of these electronic devices. For example, when involved in the construction of electronic devices, personnel may be required to wear anti-ESD wrist straps or footwear. Alternatively, the environment in which the devices are handled may be fitted with anti-ESD flooring. However, it is impossible for such measures to be expected in a domestic or other consumer environment, when the device is in a private setting and being used by consumers.

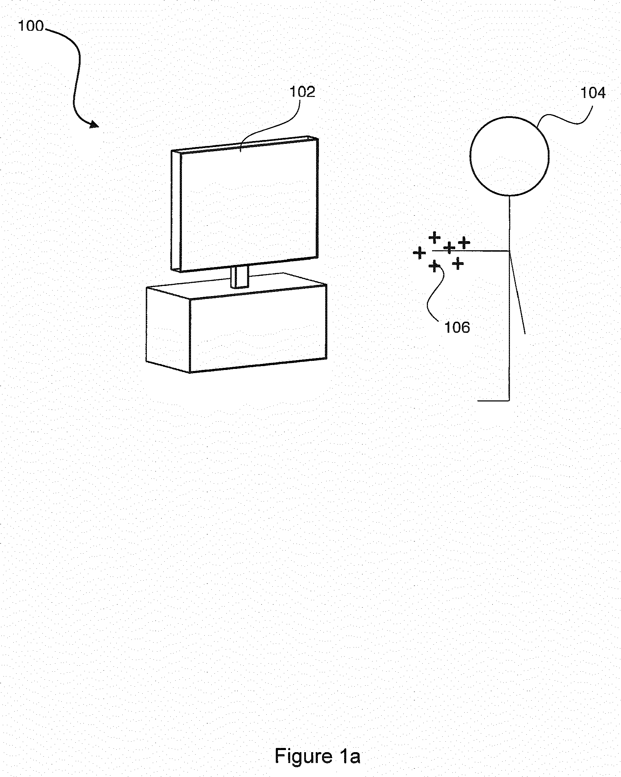

Figure 1a schematically shows an example environment 100 in which an electronic device 102 is at a safe distance from a charged entity 104, in this case a person carrying an electrostatic charge build up 106. The electronic device 102 may be for example a television, a DVD player, a set-top box, a desktop or laptop or tablet computer, etc., a video game console, a cellular phone (including a so-called "smart phone"), a printer, an electric appliance such as a "white good" (i.e. a washing machine, tumble dryer, refrigerator, freezer, etc.), etc. In this example the electronic device 102 is shown as a television. In Figure 1A, the entity 104 is not sufficiently close to the device to cause an ESD event.

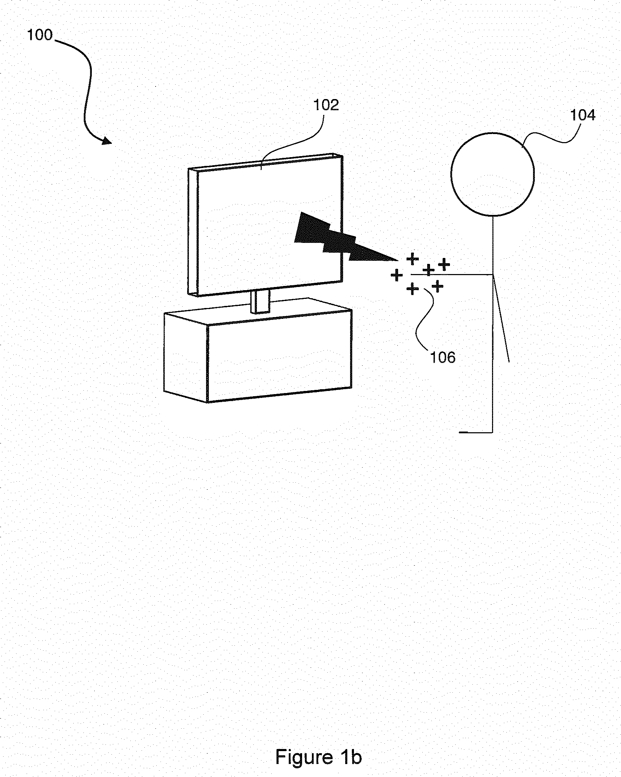

Figure 1b schematically shows the example environment 100 in which the charged entity 104 is closer to the device 102. The charged entity 104 is now sufficiently close to the device 102 to cause an ESD event in which an electrostatic discharge to the device 102 occurs.

In examples described herein, there is provided an arrangement to protect the device 102 from such ESD. The arrangement may detect the presence of an electrostatic charge build up in the vicinity of the device, thereby allowing it to act accordingly to protect the device in the case that an ESD event takes place. The arrangement may be arranged such as to protect the entire device 102. Alternatively, it may be designed to protect one or more specific components of the device 102.

A build up of electrostatic charge will have a magnetic field associated with it. If the protection arrangement detects such a magnetic field, this is taken as an indication that the device may be at risk of being damaged by ESD which may be about to take place with an entity carrying the electrostatic charge in the vicinity of the device. The protection arrangement may trigger a protection arrangement to protect the device. An entity may be considered as being in the vicinity of the electronic device for present purposes if the magnetic field associated with the electrostatic discharge is detected by the protection arrangement.

An entity becomes charged by gaining or losing charge carriers. The charged entity may be able to repel or attract charge carriers, in particular electrons, in its proximity, depending on its own electric charge and that of its surroundings. The movement of charge carriers in the surrounding regions may induce a magnetic field at a second location. Referring to Figure 1b, the initially charged entity 104 may cause a charge imbalance field at the device 102, and may or may not induce a magnetic field at the device 102.

The magnetic field detector may be contained within the device that is to be protected. Alternatively, the magnetic field detector may be located externally of the device that is to be protected. Upon detecting the magnetic field, the magnetic field detector may cause a protection arrangement to be activated to protect the device from ESD.

The protection arrangement may act to protect a device at risk of being involved in an ESD event in a number of ways. In one example, the protection arrangement may disrupt or interrupt software operating on the device. Such an interruption may cause, for example, ending the running of the software on the device, stopping the device working entirely, triggering software to restart the device, or causing the device to revert to factory settings.

Alternatively or additionally, the protection arrangement may be arranged to disable at least one earth or ground connection of the device in order to prevent ESD. As known per se, if a charged entity is brought close to a grounded or earthed device, an ESD can take place between the grounded device and the charged entity. In this example, when the protection arrangement detects a magnetic field associated with a charged entity, it may act to disable at least one earth connection of the device to prevent an ESD occurring. An electronic device can comprise a plurality of grounding mechanisms and circuits.

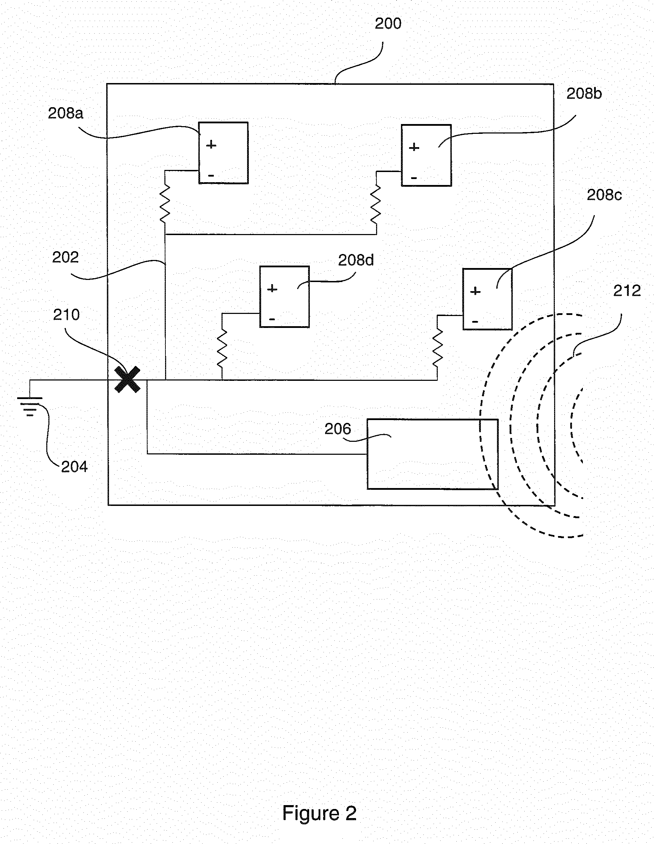

Figure 2 shows schematically an example device 200 comprising a ground circuit 202 and a common ground 204 and a number of device components 208a - 208d. The device components 208a - 208d may be for example processors, op-amps or other silicon devices, capacitors, resistors, inductors, etc. The ground circuit 202 provides each device component 208a - 208d with connections to earth 204.

The protection arrangement 206 may be arranged to sever connections between all of the device components 208a - 208d and earth 204 if a magnetic field 212 is detected in the vicinity of the device. This may be achieved by for example severing the ground connection of each device component 208a - 208d separately or by severing coming ground connections, for example at a location 210 adjacent the last connection to the common ground 204 in this example. ESD is prevented as the device 200 will no longer provide the charged entity with a route to earth 204.

Additionally or alternatively, the protection arrangement 206 may be arranged such that only particular connections to ground are severed to protect the device 200.

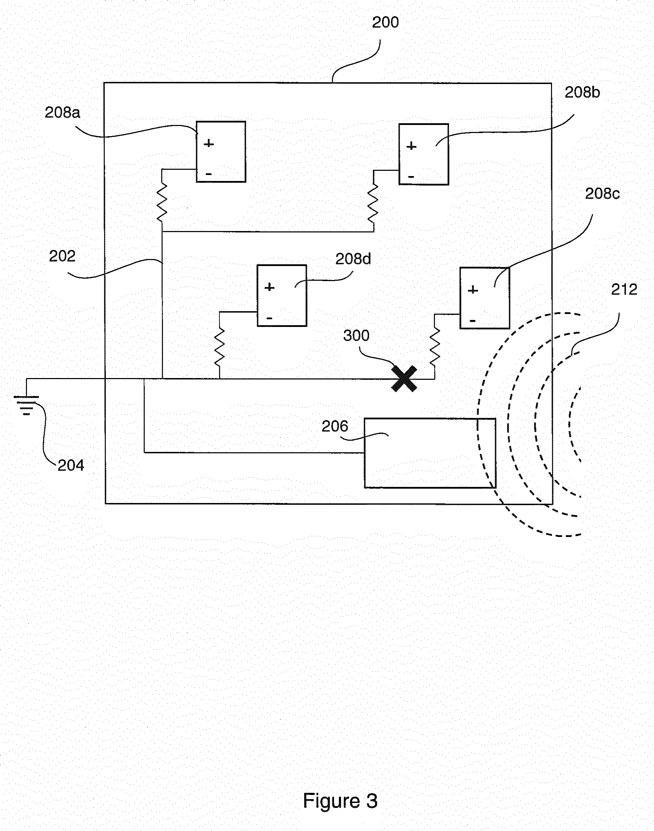

Figure 3 shows schematically the example device 200 and a nearby magnetic field 212. Upon determining that the magnetic field 212 is most likely to only interact with, say, one component 208c of the device 200, the protection arrangement 206 may sever the connection to earth 204 associated only with that component 208c. In Figure 3, the ground connection is shown as being severed at location 300 of the ground circuit 202. The results in device component 208c being disconnected from earth 204, such that the device component 208c is not able to provide any approaching charged entity with a route to earth 204. The remaining device components 208a, 208b and 208d continue to be connected to earth 204 through the ground circuit 202. At-risk component 208c is protected, without compromising the remaining components 208a, 208b and 208d of the circuit 202 and their related functionalities.

In this example, the protection arrangement 206 is shown as acting to protect only one component 208c. In another example embodiment, the protection arrangement may be arranged to sever the links to ground associated with more than one component. This may be dependent on the location of a nearby magnetic field which is detected by the protection arrangement 206.

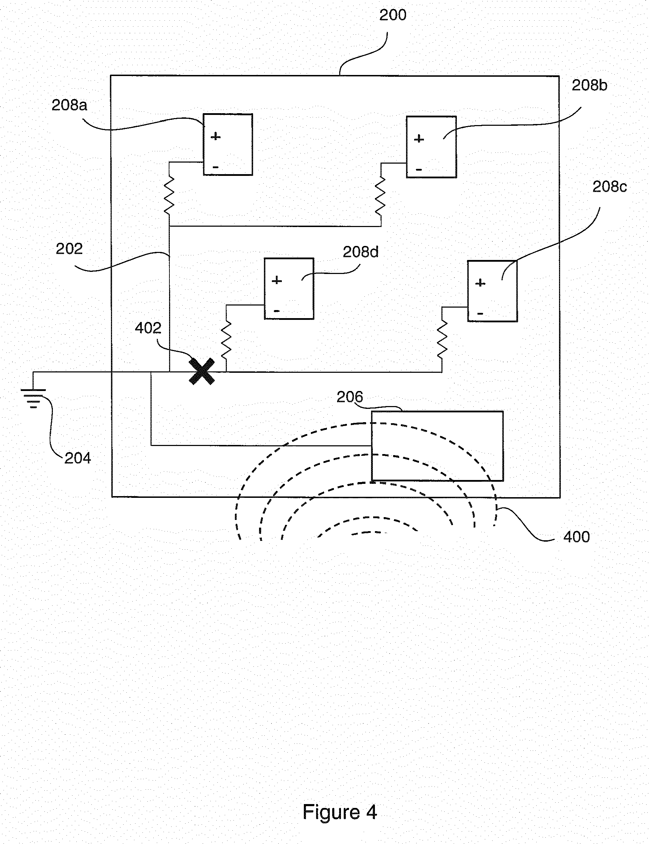

Figure 4 shows schematically the device 200 and a nearby magnetic field 400. Upon detecting the magnetic field 400, the protection arrangement 206 is able to determine that two components 208c and 208d are at risk of exposure to ESD. The protection arrangement 206 causes the ground connections for these two components 208c and 208d to be severed, in this case by severing the ground connection at a common location 402. The remaining components 208a and 208b continue to provide their functionalities uninterrupted.

In another example, the protection arrangement 308 may be arranged to disable the ground connections associated with components which are part of group. Components may be organised into groups in a number of ways. Groups may be defined by the physical location of the components within the device. For example a protection arrangement may be arranged such that if a charged entity is detected approaching to the left of the device, the ground connections of the left most components may be collectively cut to prevent an ESD between them and the charged entity. The left-most device components may be considered as a group. Alternatively, the protection arrangement may sever all other ground connections to preserve the non-exposed groups and components.

In another example, components which share a ground connection to earth may be considered a group. If the protection arrangement detects that a component is exposed to a magnetic field, the protection arrangement may sever at least one connection to earth associated with a group comprising the exposed component. Additionally or alternatively, the protection arrangement may sever the ground connections associated with the other device components or groups to preserve the non-exposed groups and components.

In another example, the grouping of components may be related to the functionality of the components. For example, the protection arrangement may detect that an audio component is exposed to a magnetic field. The protection arrangement may cut the ground connections associated with all of the audio components of the device. Additionally or alternatively, the protection arrangement may sever ground connections associated with the other device components or groups.

It will be understood that the processor or processing system or circuitry referred to herein may in practice be provided by a single chip or integrated circuit or plural chips or integrated circuits, optionally provided as a chipset, an application-specific integrated circuit (ASIC), field-programmable gate array (FPGA), digital signal processor (DSP), graphics processing units (GPUs), etc. The chip or chips may comprise circuitry (as well as possibly firmware) for embodying at least one or more of a data processor or processors, a digital signal processor or processors, baseband circuitry and radio frequency circuitry, which are configurable so as to operate in accordance with the exemplary embodiments. In this regard, the exemplary embodiments may be implemented at least in part by computer software stored in (non-transitory) memory and executable by the processor, or by hardware, or by a combination of tangibly stored software and hardware (and tangibly stored firmware).

Although at least some aspects of the embodiments described herein with reference to the drawings comprise computer processes performed in processing systems or processors, the invention also extends to computer programs, particularly computer programs on or in a carrier, adapted for putting the invention into practice. The program may be in the form of non-transitory source code, object code, a code intermediate source and object code such as in partially compiled form, or in any other non-transitory form suitable for use in the implementation of processes according to the invention. The carrier may be any entity or device capable of carrying the program. For example, the carrier may comprise a storage medium, such as a solid-state drive (SSD) or other semiconductor-based RAM; a ROM, for example a CD ROM or a semiconductor ROM; a magnetic recording medium, for example a floppy disk or hard disk; optical memory devices in general; etc.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. An apparatus for protecting a device (102, 200) from electrostatic discharge, the apparatus comprising:
a magnetic field detector arranged to detect a magnetic field (212) associated with a build up of static charge arising from an entity (104) in the vicinity of the device (102, 200); and
a controller, the controller being arranged such that if the detected build up of static charge is above a threshold value, the controller initiates a protection arrangement to prevent damage to the device (102, 200) being caused by electrostatic discharge.

2. An apparatus according to claim 1, wherein the apparatus is incorporated in the device (102, 200).

3. An apparatus according to claim 2, wherein the controller is arranged to initiate a protection arrangement that interrupts software running on the device (102, 200).

4. An apparatus according claim 2 or claim 3, wherein the device (102, 200) comprises at least one ground connection for connecting the device (102, 200) to earth (204), wherein the controller is arranged to initiate a protection arrangement that disconnects said at least one ground connection.

5. An apparatus according to any of claims 2 to 4, wherein the device (102, 200) comprises a plurality of electronic components each of which has an independent ground connection for connecting the electronic component directly to earth (204), wherein the controller is arranged to initiate a protection arrangement that disconnects the ground connection of each of the electronic components.

6. An apparatus according to any of claims 2 to 5, wherein the device (102, 200) comprises a plurality of electronic components each of which has a ground connection to a main ground connection for connection to earth (204), wherein the controller is arranged to initiate a protection arrangement that disconnects the ground connection of each of the electronic components to the main ground connection.

7. An apparatus according to any of claims 2 to 6, wherein the device (102, 200) comprises a plurality of groups of electronic components, each group comprising a plurality of electronic components and each group being connected directly to an independent common ground connection for connecting the electronic components of the group directly to earth (204), wherein the controller is arranged to initiate a protection arrangement that disconnects the ground connections of each of the groups of electronic components.

8. An apparatus according to any of claims 2 to 7, wherein the device (102, 200) comprises a plurality of electronic components each of which has a ground connection for connection to earth (204), wherein the controller is arranged to initiate a protection arrangement that connects the ground connection of at least one electronic component directly to earth without connecting at least one of the remaining electronic components to earth.

9. A method of protecting a device (102, 200) from electrostatic discharge, the method comprising:
detecting a magnetic field (212) associated with a build up of static charge arising from an entity (104) in the vicinity of the device (102, 200);
determining whether the detected build up of static charge is above a threshold value associated with the device (102, 200); and
initiating a protection arrangement to prevent damage to the device (102, 200) if the detected build up of static charge is above a threshold thereby to prevent damage to the device (102, 200) being caused by electrostatic discharge.

10. A method according to claim 9, wherein initiating a protection arrangement comprises interrupting software running on the device (102, 200).

11. A method according to claim 9 or claim 10, wherein the device (102, 200) comprises at least one ground connection, wherein initiating a protection arrangement comprises disconnecting the ground connection associated with the device (102, 200).

12. A method according to any of claims 9 to 11, wherein the device (102, 200) comprises a plurality of electronic components each of which has an independent ground connection for connecting the electronic component directly to earth (204), wherein initiating a protection arrangement comprises disconnecting the ground connection of each of the electronic components.

13. A method according to any of claims 9 to 12, wherein the device (102, 200) comprises a plurality of electronic components each of which has a ground connection to a main ground connection for connection to earth (204), wherein initiating a protection arrangement comprises disconnecting the ground connection of each of the electronic components to the main ground connection.

14. A method according to any of claim 9 to 13, wherein the device (102, 200) comprises a plurality of groups of electronic components, each group comprising a plurality of electronic components and each group being connected directly to an independent common ground connection for connecting the electronic components of the group directly to earth (204), wherein initiating a protection arrangement comprises disconnecting the ground connections of each of the groups of electronic components.

15. A method according to any of claims 9 to 14, wherein the device (102, 200) comprises a plurality of electronic components each of which has a ground connection for connection to earth (204), wherein initiating a protection arrangement comprises initiating a protection arrangement that connects the ground connection of at least one electronic component directly to earth without connecting at least one of the remaining electronic components to earth.
